# EUROPEAN PATENT APPLICATION

(11) **EP 4 697 551 A1**
(43) Date of publication of application: **18.02.2026**
(21) Application number: 24894705.3
(22) Date of filing: 22.11.2024
(51) Int. Cl.: H02J 7/00, G01R 31/382, H01M 10/44, H01M 10/052, H01M 4/134, H01M 10/42

(54) **BATTERY MANAGEMENT DEVICE AND CHARGING CONTROL METHOD THEREBY**

(30) Priority: 24.11.2023 KR 20230165889
(71) Applicant: LG Energy Solution, Ltd., Seoul 07335 (KR)
(72) Inventor: KIM, Junghyun, Daejeon 34122 (KR); KIM, Yunjung, Daejeon 34122 (KR)
(74) Representative: Goddar, Heinz J.
(86) International application number: PCT/KR2024/018693
(87) International publication number: WO 2025/110814

(57) **Abstract**

Provided is a charging control method, performed by a battery management device, for a battery including a lithium metal as at least part of a negative electrode, the method comprising the steps of: charging a battery on the basis of a first charging rate; and charging the battery on the basis of a second charging rate that is higher than the first charging rate, in response to a state-of-charge (SoC) of the battery reaching a threshold value.

## Description

### Technical Field

This application claims the benefit of priority to Korean Patent Application No. 10-2023-0165889, filed on November 24, 2023, the entire contents of which are incorporated herein as part of this specification.

The present disclosure relates to a battery management device configured to control the charging of a battery including lithium metal as at least a portion of the anode, and a charging control method thereof.

### Background Art

Regarding lithium-ion batteries, which are widely used in the battery field, various charging methods have been developed to increase charging speed while having less adverse effects on the battery. One of these charging methods is a method in which at the beginning of the charge, when a state-of-charge (SoC) of the battery is low, a high current rate (C-rate) is applied, and as the charge progresses and the SoC gradually increases, the C-rate is gradually lowered. The principle of this prior art is to utilize characteristic that at the beginning of the charging process, there are many empty spaces in the anode's graphite where lithium ions can penetrate, so even if a high C-rate is applied, less dendrite is formed, so the adverse effects on the battery are relatively small.

However, this type of charging method is difficult to apply to next-generation batteries that are expected to replace lithium-ion batteries. In other words, since next-generation batteries, for example, lithium-sulfur batteries, lithium metal batteries or all-solid-state batteries, contain lithium metal in the anode, even in the early stages of charging, when a high C-rate is applied, much dendrite is formed, and ultimately, there is a problem that it has a significant negative impact on the battery, and thus it is difficult to apply the charging method according to the existing technology described above to the next-generation batteries.

Therefore, needed is a new charging method applicable to next-generation batteries including lithium metal as at least a portion of the anode, and to increase charging speed while minimizing adverse effects on the battery.

### Detailed Description of the Invention

### Technical Goals

The disclosed example embodiments are intended to provide a battery management device and a charging control method thereof. Specifically, the purpose of the present disclosure is to propose a charging method by which the charging speed of a battery including lithium metal in at least a portion of the anode is increased while adverse effects being minimized on the battery, by increasing the C-rate and charging the battery as the SoC of the battery reaches a threshold value.

Further, the purpose of the present disclosure is to suggest various methods by which a threshold value is determined at which the C-rate may be increased and how much the C-rate is to be increased is determined after the threshold value is reached.

The technical tasks to be achieved by the present example embodiments are not limited to the technical tasks described above, and other technical tasks may be inferred from the following example embodiments.

### Technical solutions

According to an aspect, there provided is a charging control method of a battery including lithium metal as at least a portion of an anode, performed by a battery management device, the method including charging the battery based on a first C-rate, and charging the battery based on a second C-rate that is higher than the first C-rate in response to that a SoC of the battery reaches a threshold value.

According to an example embodiment of the present disclosure, the threshold value may be determined based on a profile indicating a voltage of the anode according to the SoC of the battery.

Further, according to an example embodiment of the present disclosure, the threshold value may be determined based on a SoC corresponding to an inflection point of the profile.

Further, according to an example embodiment of the present disclosure, based on the profile, the threshold value may be determined based on a SoC corresponding to the inflection point where the voltage of the anode increases, then decreases, and then increases again as the battery is charged.

Further, according to an example embodiment of the present disclosure, the threshold value may be determined further based on at least one of temperature, humidity, pressure and a state-of-health (SoH).

Further, according to an example embodiment of the present disclosure, the threshold value may be determined, by analyzing chemical reactions that occur at the anode during a charging process of the battery, based on a SoC of a point at which a ratio of a lithium metal reaction among the chemical reactions decreases to equal to or less than a threshold ratio.

Further, according to an example embodiment of the present disclosure, the first C-rate and the second C-rate may have a difference that is determined based on at least one of temperature, humidity, pressure and a SoH.

Further, according to an example embodiment of the present disclosure, the second C-rate may be selected in a range exceeding the first C-rate and equal to or less than a third C-rate.

Further, according to an example embodiment of the present disclosure, the third C-rate may be selected as a largest in size, among candidate C-rates that at least one of the discharge capacity remaining ratio and Coulombic efficiency for a charging result applied in response to reaching the threshold value is identified as being included in a normal range.

Further, according to an example embodiment of the present disclosure, the first C-rate may be 0.2C and the second C-rate may be 0.5C when the battery includes sulfur as at least a portion of a cathode.

According to an aspect, there provided is a battery management system configured to control charging a battery including lithium metal as at least a portion of an anode, the battery management system including one or more sensors, a processor and a memory configured to store one or more instructions, wherein the processor is configured to, by executing the one or more instructions, charge the battery based on a first C-rate, and charge the battery based on a second C-rate that is higher than the first C-rate in response to that a SoC of the battery reaches a threshold value.

Further, according to an example embodiment of the present disclosure, the threshold value may be determined based on a profile indicating a voltage of the anode according to the SoC of the battery.

Further, according to an example embodiment of the present disclosure, the threshold value may be determined based on a SoC corresponding to an inflection point of the profile.

Further, according to an example embodiment of the present disclosure, based on the profile, the threshold value may be determined based on a SoC corresponding to the inflection point where the voltage of the anode increases, then decreases, and then increases again as the battery is charged.

Further, according to an example embodiment of the present disclosure, the threshold value may be determined further based on at least one of temperature, humidity, pressure and a SoH.

Further, according to an example embodiment of the present disclosure, the threshold value may be determined, by analyzing chemical reactions that occur at the anode during a charging process of the battery, based on a SoC of a point at which a ratio of a lithium metal reaction among the chemical reactions decreases to equal to or less than a threshold ratio.

Further, according to an example embodiment of the present disclosure, the first C-rate and the second C-rate may have a difference that is determined based on at least one of temperature, humidity, pressure and a SoH.

Further, according to an example embodiment of the present disclosure, the second C-rate may be selected in a range exceeding the first C-rate and equal to or less than a third C-rate.

Further, according to an example embodiment of the present disclosure, the third C-rate may be selected as a largest in size, among candidate C-rates that at least one of the discharge capacity remaining ratio and Coulombic efficiency for a charging result applied in response to reaching the threshold value is identified as being included in a normal range.

Further, according to an example embodiment of the present disclosure, the first C-rate may be 0.2C and the second C-rate may be 0.5C when the battery comprises sulfur as at least a portion of a cathode.

According to an aspect, there provided is a non-transitory computer-readable recording medium having a program for executing the charging control method on a computer.

Additional aspects of example embodiments will be set forth in part in the description that follows and, in part, will be apparent from the description, or may be learned by practice of the disclosure.

### Effects of the Invention

According to the suggested example embodiments, one or more of the following effects may be expected.

According to the example embodiments of the present disclosure, it is possible to minimize adverse effects on next-generation batteries including lithium metal as at least a portion of the anode, and to increase the charging speed.

Further, according to the example embodiments of the present disclosure, it is possible to secure the optimized charging speed of the next-generation battery in any situation by increasing the C-rate based on the optimized threshold value for each situation.

Further, according to the example embodiments of the present disclosure, it is possible to determine the limit of the C-rate that may be increased after reaching the threshold value based on the discharge capacity remaining ratio and the Coulombic efficiency.

The effects of the present disclosure are not limited to the effects described above, and other effects not described will be apparent to those skilled in the art from the description of the claims.

### Brief Description of Drawings

FIG. 1 illustrates the correlation of a battery management device according to an example embodiment.
FIG. 2 is a flowchart of a charging control method according to an example embodiment.
FIG. 3 is a graph illustrating the increase in C-rate after reaching a threshold value according to an example embodiment.
FIG. 4 is a graph illustrating a profile representing the voltage of the anode referenced to determine the threshold value according to an example embodiment.
FIG. 5 is a graph illustrating the discharge capacity remaining ratio and the Coulombic efficiency when a C-rate 2-1 and a C-rate 2-2 are applied after a threshold value is reached according to an example embodiment.
FIG. 6 is a table including information about threshold values, the first C-rate and the second C-rate according to the temperature, the humidity, the pressure and the SoH according to an example embodiment.
FIG. 7 illustrates a block diagram of a battery management device according to an example embodiment.

### Mode for Carrying Out the Invention

Terms used in the example embodiments are selected from currently widely used general terms when possible while considering the functions in the present disclosure. However, the terms may vary depending on the intention or precedent of a person skilled in the art, the emergence of new technology, and the like. Further, in certain cases, there are also terms arbitrarily selected by the applicant, and in the cases, the meaning will be described in detail in the corresponding descriptions. Therefore, the terms used in the present disclosure should be defined based on the meaning of the terms and the contents of the present disclosure, rather than the simple names of the terms.

Throughout the specification, when a part is described as "comprising or including" a component, it does not exclude another component but may further include another component unless otherwise stated.

Expression "at least one of a, b and c" described throughout the specification may include "a alone," "b alone," "c alone," "a and b," "a and c," "b and c" or "all of a, b and c."

In the present disclosure, a "terminal" may be implemented as, for example, a computer or a portable terminal capable of accessing a server or another terminal through a network. Here, the computer may include, for example, a notebook, a desktop computer, and/or a laptop computer that are equipped with a web browser. The portable terminal may be a wireless communication device ensuring portability and mobility, and include (but is not limited to) any type of handheld wireless communication device, for example, a tablet PC, a smartphone, a communication-based terminal such as international mobile telecommunication (IMT), code division multiple access (CDMA), W-code division multiple access (W-CDMA), long term evolution (LTE), or the like.

Hereinafter, example embodiments of the present disclosure will be described in detail with reference to the accompanying drawings so that those of ordinary skill in the art to which the present disclosure pertains may easily implement them. However, the present disclosure may be implemented in multiple different forms and is not limited to the example embodiments described herein.

Hereinafter, example embodiments will be described in detail with reference to the drawings.

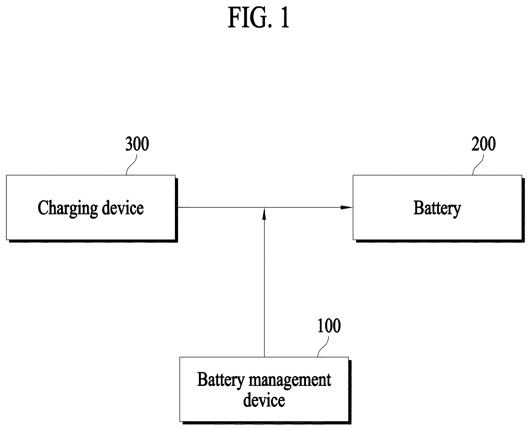

FIG. 1 illustrates the correlation of a battery management device according to an example embodiment.

Referring to FIG. 1, a battery management device 100 may operate in conjunction with a battery 200 and a charging device 300. Meanwhile, FIG. 1 illustrates only the components relevant to the example embodiment. Therefore, it will be understood by those skilled in the art related to the example embodiment that other general components may be included in addition to the components illustrated in FIG. 1.

The battery management device 100 may charge the battery 200 by controlling the current input from the charging device 300. Here, the charging device 300 may be a charger for a commonly used battery, and may have various forms depending on the intended use and usage pattern of the battery. The battery management device 100 may control the charging of the battery in a various ways, including several ways such as directly controlling the charging device 300, transmitting the current and voltage information required for the charging device 300 and controlling the current input from the charging device 300 in the middle, but is not limited above-described example embodiments.

The battery 200 envisioned in the present disclosure is a battery including lithium metal as at least a portion of the anode, and for example, the battery 200 may be at least one of next-generation batteries such as a lithium-sulfur battery, a lithium metal battery and an all-solid-state battery. In other words, in addition to above-described example embodiments, the charging control method of the present disclosure described below may be applied to various batteries including lithium metal as at least a portion of the anode, and the charging control method is not limited to the above-described example embodiments.

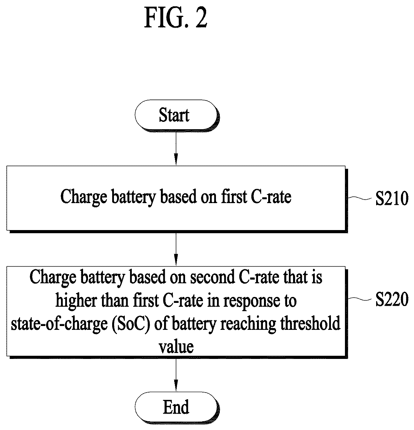

A charging control method according to an example embodiment of the present disclosure is described referring to FIG. 2.

FIG. 2 is a flowchart of a charging control method according to an example embodiment.

In operation S210, the battery management device 100 may charge the battery 200 based on the first C-rate. In operation S220, the battery management device 100 may charge the battery based on a second C-rate that is higher than the first C-rate in response to the SoC of the battery 200 reaching the threshold value. Each operation is described in more detail below.

First, the battery management device 100 may charge the battery 200 based on the first C-rate. Here, the first C-rate and the second C-rate applied after reaching the SoC threshold value may be a value representing the speed at which the battery is charged, expressed as C-rate. Specifically, the C-rate is a value calculated by dividing the charging current by the rated capacity of the battery, and the unit may be expressed as C=A/Ah. Accordingly, the battery management device 100 may determine the charging current to be input to the battery based on the first C-rate or the second C-rate, and may charge the battery with the corresponding charging current by working in conjunction with the charging device 300.

When operation S210 is described again, the battery management device 100 may charge the battery 200 at the first C-rate until the SoC reaches the threshold value. According to an example embodiment, the first C-rate may be a value selected based on several values that may quantitatively measure the degradation of battery performance due to an increase in the number of charge/discharge cycles of the battery 200, for example, the discharge capacity remaining ratio or the Coulombic efficiency. Alternatively, according to an example embodiment, it may be a value selected with in a range in which too much dendrite is not generated by the reaction of lithium metal included as at least a portion of the anode.

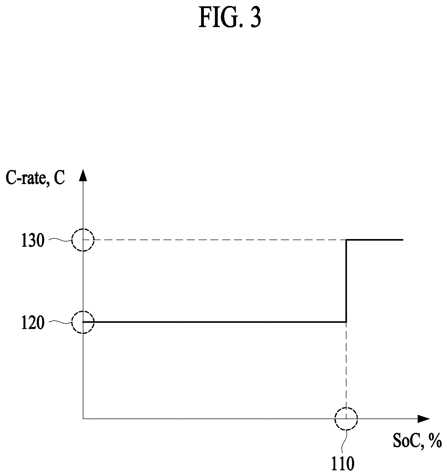

The battery management device 100 may continuously measure, or monitor, the SoC of the battery 200 while charging the battery 200 at the first C-rate. After then, the battery management device 100 may detect when the SoC reaches a threshold value by monitoring the SoC. In response to the SoC reaching the threshold value, the battery management device 100 may charge the battery 200 based on the second C-rate that is higher than the first C-rate. FIG. 3 may be referred to for an example embodiment of increasing the C-rate in this way.

FIG. 3 is a graph illustrating the increase in C-rate after reaching the threshold value according to an example embodiment.

As illustrated in FIG. 3, the battery management device 100 may charge the battery 200 based on a first C-rate 120 before the SoC reaches a threshold value 110, and in response to the SoC reaching the threshold value 110, and then charge the battery 200 based on a second C-rate 130 that is higher than the first C-rate 120. As illustrated in the drawing, the unit of the C-rate may be C, and the unit of the SoC may be %.

Below described are a threshold value as a criterion for increasing C-rate and the second C-rate that is increased in response to the SoC reaching the threshold value.

First, according to an example embodiment, with analyzing chemical reactions that occur at the anode during the battery charging process, the threshold value may be determined based on the SoC at which the ratio of a lithium metal reaction to the chemical reactions decreases below the threshold ratio. Since the lithium metal, which is included as at least a portion of the anode, can induce dendrite formation through the chemical reaction at the anode, after the ratio of the chemical reaction by the lithium metal decreases, even if the C-rate is increased, less dendrite formation may be induced. Here, the threshold ratio may be simply set to 50%, but may be set in various ways depending on the intention of a designer. In an example embodiment, the threshold ratio may be set high for fast charging of the battery, or after the threshold ratio is set low for the battery stability, a threshold value may be set based on the SoC at the point where the threshold ratio is reached. In other words, the threshold ratio for determining the threshold value is not limited to any value, and may have various values depending on the intention of a designer.

According to an example embodiment, in the case of the lithium-sulfur batteries, which contain lithium metal as at least a portion of the anode, a threshold value may be determined based on the SoC at which the chemical reaction at the anode changes from a lithium metal reaction to a lithium-sulfur shuttle reaction. For batteries including lithium metal as at least a portion of the anode, for example, lithium metal batteries or all-solid-state batteries, after a certain point of SoC, the ratio of chemical reactions of other components in the cathode or electrolyte instead of the reaction by lithium metal at the anode may exceed a threshold ratio. Based on the SoC at the specific point, a threshold value may be determined.

Here, the change in the ratio of the chemical reaction occurring at the anode is directly identified through various chemical reaction analysis methods known in the past, or may indirectly identified through changes in other values. In an example embodiment for indirectly identifying the change in the ratio of the chemical reaction, it may be possible to estimate the change in the ratio of the chemical reaction through the voltage of the anode. Of course, the change in the anode voltage may not necessarily occur due to a change in the ratio of such chemical reactions.

According to an example embodiment, the threshold value that may act as a trigger for the above-described C-rate increase may be determined based on a profile indicating an anode voltage according to the SoC of the battery 200. Here, the anode voltage in the profile may have an inflection point, and accordingly, the threshold value may be determined based on the SoC corresponding to the inflection point of the profile. Here, the inflection point may not be an inflection point in the mathematical sense, and may be the point where the trend of anode voltage due to charging temporarily changes.

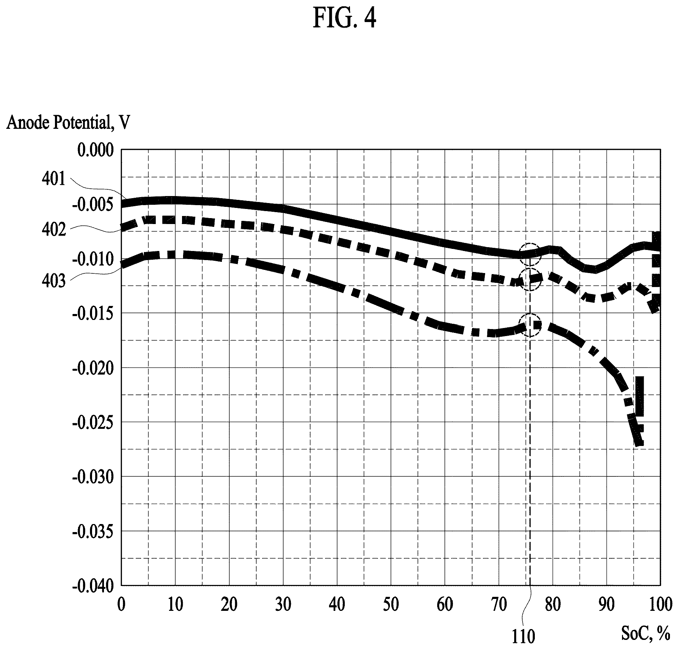

According to an example embodiment, such an inflection point may be the point where the absolute value of the anode voltage increases, then decreases and then increases again on the profile as the battery 200 charges. FIG. 4 may be referred to for an example embodiment of such an inflection point in a lithium-sulfur battery.

FIG. 4 is a graph illustrating a profile representing the voltage of the anode referenced to determine the threshold value according to an example embodiment.

Referring to FIG. 4, a first voltage graph to a third voltage graph (401, 402, 403) may be identified. As will be described later, the first voltage 401 may be the case where the first C-rate is maintained throughout the charging process of the lithium-sulfur battery, a second voltage graph 402 may be the case where the C-rate 2-1, which is higher than the first C-rate, is applied in response to reaching the threshold value of the SoC, and the third voltage graph 403 may be a case where the C-rate 2-2 higher than the first C-rate is applied in response to reaching the threshold value of the SoC. As described above, in all three graphs, it is identified that the absolute value of the anode voltage increases at a point corresponding to the threshold value 110, then decreases, and then increases again. The threshold value may be determined by the SoC value of such an inflection point, or may be chosen within a certain range corresponding to the inflection point. As illustrated in the drawing, the unit of the anode voltage maybe V, and the unit of the SoC may be %.

The anode voltage profile illustrated in FIG. 4 is only an example embodiment related to a lithium-sulfur battery, and the profile may be derived differently depending on the type of battery. Accordingly, in this way, the inflection point on the profile where the trend of the anode voltage changes may also be derived in various ways, and in some cases, there may be multiple inflection points. Further, the formation of the inflection point may be due to, but is not limited to, a change in the ratio of the chemical reaction described above, and an example embodiment that determines a threshold value based on an inflection point formed by other factors will also be included in the scope of the present disclosure.

After then, in response to the SoC reaching the threshold value, the battery management device 100 may charge the battery 200 based on the second C-rate that is higher than the first C-rate. Here, the second C-rate may be selected within a range exceeding the first C-rate and less than or equal to the third C-rate. Here, the third C-rate may be a value corresponding to the maximum C-rate, and even after reaching the threshold value, applying a C-rate that is too high may have a negative impact on the battery and thus the third C-rate may be a value that is set to prevent this. Such a third C-rate may be selected as the one with the largest size among candidate C-rates for which at least one of the discharge capacity remaining ratio and Coulombic efficiency for the charging result applied in response to reaching the threshold value is identified to be within the normal range. In other words, a C-rate of which size is the greatest and of which largest adverse effect on the battery identified in aspects of the discharge capacity remaining ratio and Coulombic efficiency is within the acceptable range may be selected as the third C-rate. According to an example embodiment, the normal range may be determined based on the discharge capacity remaining ratio and the Coulombic efficiency of the control group to which the same first C-rate is applied throughout the charging process.

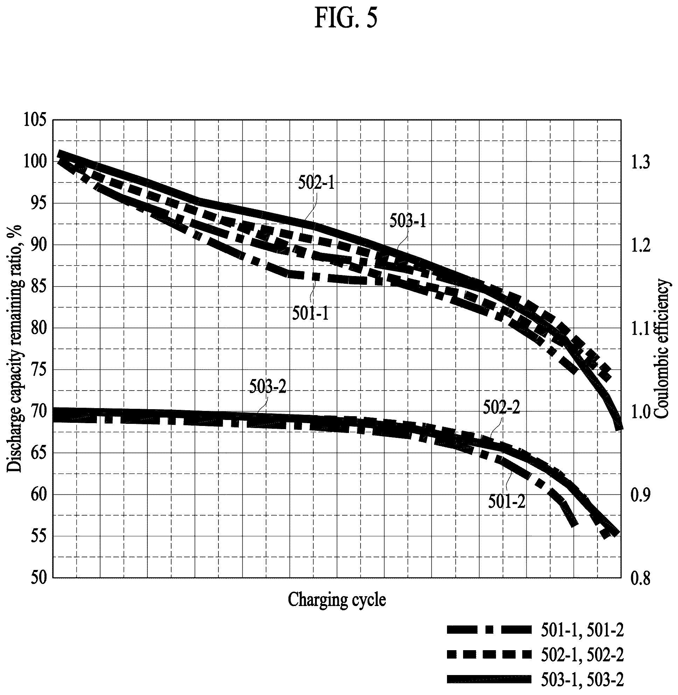

Accordingly, the second C-rate may be selected by the administrator within a range exceeding the first C-rate and below the third C-rate by the battery management device 100, or may be selected within a range by weighting either battery stability or fast charging depending on the situation through a given algorithm. FIG. 5 is referred to in order for examining the case where the discharge capacity remaining ratio and the Coulombic efficiency, which may be used to select a third C-rate, are within the normal range.

FIG. 5 is a graph illustrating the discharge capacity remaining ratio and the Coulombic efficiency when the C-rate 2-1 and the C-rate 2-2 are applied after the threshold value is reached according to an example embodiment.

Here, the discharge capacity remaining ratio may be expressed as a percentage unit of the amount of discharge when the battery is connected to an open circuit, and the Coulombic efficiency may indicate the ratio of charge capacity and discharge capacity. In FIG. 5, a first upper graph 501-1 to a third upper graph 503-1 show the discharge capacity remaining ratio as the number of charging cycles on the horizontal axis increases, and the corresponding values may be on the vertical axis on the left. Further, a first lower graph 501-2 to a third lower graph 503-2 show the Coulombic efficiency as the number of charging cycles on the horizontal axis increases, and the corresponding values may be on the vertical axis on the right. Further, FIG. 5 may be linked to the graph of FIG. 4. In other words, the first upper graph 501-1 and the first lower graph 501-2, which are expressed as dashed lines like the index, may correspond to the first voltage graph 401 of FIG. 4. In other words, the first upper graph 501-1 and the first lower graph 501-2 may represent the discharge capacity remaining ratio and the Coulombic efficiency when the first C-rate is applied throughout the charging process, like the first voltage graph 4010, and thus the first upper graph 501-1 and the first lower graph 501-2 may be identified as graphs of the control group. Further, a second upper graph 502-1 and a second lower graph 502-2, which are expressed as dotted lines like the index, may correspond to the second voltage graph 402 of FIG. 4, and may represent the discharge capacity remaining ratio and Coulombic efficiency when the C-rate 2-1 is applied after the SoC reaches the threshold value. Further, the third upper graph 503-1 and the third lower graph 503-2, which are expressed as solid lines like the index, correspond to the third voltage graph 403 of FIG. 4, and may represent the discharge capacity remaining ratio and Coulombic efficiency when C-rate 202 is applied after the SoC reaches the threshold value. As identified in FIG. 5, the second upper graph 502-1 and the second lower graph 502-2, and the third upper graph 503-1 and the third lower graph 503-2 do not differ much from the first upper graph 501-1 and the first lower graph 501-2. In this case, both C-rate 2-1 and the C-rate 2-2 are within the normal range, which indicates that they may be at least some of the candidate C-rates. In this way, among the candidate C-rates included in the normal range in terms of discharge capacity remaining ratio and Coulombic efficiency, the one with the largest size may be selected as the third C-rate. Of course, an example embodiment that is based only one of the two, rather than both the discharge capacity remaining ratio and the Coulombic efficiency, would also be in the scope of the present disclosure.

According to an example embodiment, when the battery 200 includes sulfur as at least a portion of the cathode, in other words, for example, in the case of a lithium-sulfur battery, the first C-rate may be determined as 0.2C and the second C-rate as 0.5C. The first C-rate and the second C-rate may be determined according to the example embodiments described above.

In addition to the change in the profile or chemical reaction ratio indicating the voltage of the anode described above, the threshold value described above may be further determined based on at least one of the temperature, the humidity, the pressure and the SoH of the battery 200. For example, when the temperature is high, changes such as the inflection point appearing earlier on the profile indicating the anode voltage or the ratio of the reaction by lithium metal decreasing more quickly may occur, and in such cases, the threshold value may be determined lower, and changes in the threshold value may be identified similarly in relation to humidity, pressure and so on. Further, even if the SoH value is low, the ratio of reactions by lithium metal may drop more quickly because lithium metal has already been consumed in large quantities, or the inflection point may appear earlier on the profile representing the anode voltage, and accordingly, the threshold value may be set lower. All of the situations described above are example embodiments, and the opposite of the example embodiments, for example, setting a higher threshold value when the temperature is high or the SoH value is low, is also within the scope of the present disclosure. Furthermore, any case where the threshold value is determined based on at least one of the temperature, the humidity, the pressure and the SoH is included in the scope of the present disclosure.

Further, the difference between the first C-rate and the second C-rate, in other words, how much to increase the C-rate, may also be determined based on at least one of the temperature, the humidity, the pressure and the SoH. For example, at high temperatures, which may accelerate the formation of dendrites, or when the SoH value is low by which it is predicted that much dendrite has already formed, the second C-rate may be set higher than the first C-rate, but the difference may be somewhat smaller. The situations described above are all example embodiments, and the opposite of the above-described example embodiments, for example, setting the second C-rate higher when the temperature is high or the SoH value is low, is also within the scope of the present disclosure.

Further, in another example embodiment, based on the above-described discharge capacity remaining ratio and Coulombic efficiency, the first C-rate and the second C-rate may be determined within a large range, and the combination of the first C-rate may be determined by taking into account at least some of the temperature, the humidity, the pressure and the SoH. For example, possible example embodiments are also that dendrite formation is prevented by lowering the first C-rate applied before reaching the threshold value where dendrite formation is highly likely when the described SoH is low, and the charging speed is up by increasing the second C-rate applied after reaching a threshold value where the possibility of dendrite formation is low.

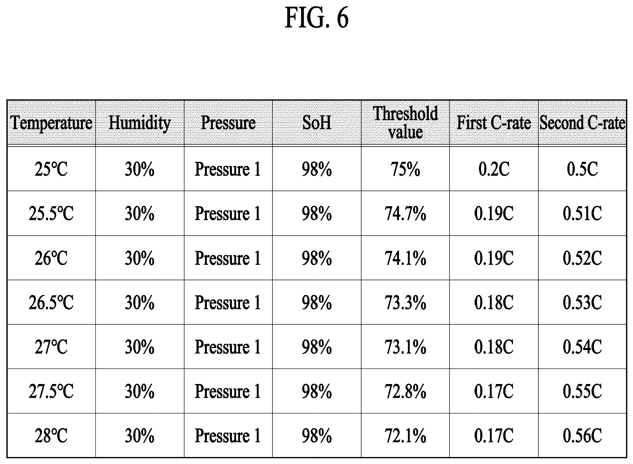

According to an example embodiment, together with the temperature, the humidity, the pressure and the SoH, the battery management device 100 may refer to the table to determine the threshold value, the first C-rate and the second C-rate. In other words, the status information of the battery 200 at the point in time may be identified, and the battery 200 may be charged with the application of the threshold value, the first C-rate and the second C-rate that are optimized for the status information based on the table including information on the temperature, the humidity, the pressure and the SoH calculated threshold value, the first C-rate and the second C-rate. FIG. 6 is referred to for example embodiments thereof.

FIG. 6 is a table including information about the threshold values, the first C-rate and the second C-rate according to the temperature, the humidity, the pressure and the SoH according to an example embodiment.

Referring to FIG. 6, a table including information about the threshold value, the first C-rate and the second C-rate as the temperature increases from 25°C to 28°C may be found when the humidity, the pressure and the SoH are 30%, 1 atm and 98%, respectively. As described above, the table may be set so that as the temperature increases, the threshold value and the first C-rate decrease, and the second C-rate increases. According to an example embodiment, the battery management device 100 may identify status information by measuring the temperature, the humidity and atmospheric pressure inside the cell as well as the SoH of the cell, and then charge the battery 200 by finding the combination of temperature, the humidity, the pressure and the SoH in the table that has the highest similarity to the status information and applying the corresponding threshold value, the corresponding first C-rate value and the corresponding second C-rate value. For convenience, FIG. 6 only illustrates the changes in threshold values, the first C-rate and the second C-rate according to the change in temperature, but an actual table may include information on threshold values, first C-rate values and second C-rate values, which vary depending on the humidity, the pressure and the SoH. Further, the trends of threshold value, first C-rate and second C-rate according to the temperature, the humidity, the pressure and the SoH shown in the table are only examples, and example embodiments in which threshold values, first C-rate and second C-rate are set according to different trends will also be included in the scope of the present disclosure.

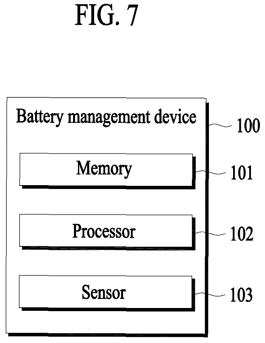

FIG. 7 is referred to for describing the configuration of the battery management device 100 configured to control the charging of the battery 200 including lithium metal as at least a portion of the anode.

FIG. 7 illustrates a block diagram of an electronic device according to an example embodiment.

The battery management device 100 may include, according to an example embodiment, a memory 101, a processor 102, and one or more sensors 103. The battery management device 100 illustrated in FIG. 7 illustrates only the components relevant to the example embodiment. Therefore, it will be understood by those skilled in the art that other general components may be included in addition to the components illustrated in FIG. 7 as described herein. In an example embodiment, the processor 102 may be included in a controller.

The one or more sensors 103 may include a sensor for measuring at least some of temperature, voltage and current used by the battery management device 100 to measure the condition of the battery cells.

The processor 102 may control the overall operation of the battery management device 100 and may process data and signals. The processor 102 may consist of at least one hardware unit. Further, the processor 102 may be operated by one or more software modules generated by executing program code stored in the memory 101. Since the processor 102 may include memory, the processor 102 may control the overall operation of the battery management device 100 and process data and signals by executing program codes stored in the memory.

The processor 102 may be configured to charge the battery based on the first C-rate by performing one or more instructions, and charge the battery based on a second C-rate that is higher than the first C-rate in response to the SoC of the battery reaching a threshold value. Further, the processor 102 may be configured to perform operations to perform a charging control method for a battery including the above-described lithium metal as at least a portion of an anode.

According to an example embodiment, the battery management device 100 may additionally include a transceiver for performing wired/wireless communication. The battery management device 100 may communicate with external electronic devices using a transceiver. The external electronic device may be terminal or a server. Further, communication technologies utilized by the transceiver may include global system for mobile communication (GSM), code division multi access (CDMA), long term evolution (LTE), 5G, wireless LAN (WLAN), Wireless-Fidelity (Wi-Fi), Bluetooth^{™}, radio frequency identification (RFID), infrared data association (IrDA), ZigBee, near field communication (NFC) and so on.

The system and various apparatuses according to the above-described example embodiments may include a controller, a memory for storing and executing program data, a permanent storage such as a disk drive, and/or a user interface device such as a communication port, a touch panel, a key and/or a button that communicates with an external device. Methods implemented as software modules or algorithms may be stored in a computer-readable recording medium as computer-readable codes or program instructions executable on the controller. Here, the computer-readable recording medium includes a magnetic storage medium (for example, ROMs, RAMs, floppy disks and hard disks) and an optically readable medium (for example, CD-ROMs and DVDs). The computer-readable recording medium may be distributed among network-connected computer systems, so that the computer-readable codes may be stored and executed in a distributed manner. The medium may be readable by a computer, stored in a memory, and executed on the controller.

The example embodiments may be represented by functional block elements and various processing steps. The functional blocks may be implemented in any number of hardware and/or software configurations that perform specific functions. For example, an example embodiment may adopt integrated circuit configurations, such as memory, processing, logic and/or look-up table, that may execute various functions by the control of one or more microprocessors or other control devices. Similar to that elements may be implemented as software programming or software elements, the example embodiments may be implemented in a programming or scripting language such as C, C++, Java, assembler, etc., including various algorithms implemented as a combination of data structures, processes, routines, or other programming constructs. Functional aspects may be implemented in an algorithm running on one or more processors. Further, the example embodiments may adopt the existing art for electronic environment setting, signal processing, and/or data processing. Terms such as "mechanism," "element," "means" and "configuration" may be used broadly and are not limited to mechanical and physical elements. The terms may include the meaning of a series of routines of software in association with a processor or the like.

The above-described example embodiments are merely examples, and other embodiments may be implemented within the scope of the claims to be described later.

## Claims

1. A charging control method of a battery comprising lithium metal as at least a portion of an anode, performed by a battery management device, the method comprising:
charging the battery based on a first C-rate; and
charging the battery based on a second C-rate that is higher than the first C-rate in response to a state-of-charge (SoC) of the battery reaching a threshold value.

2. The charging control method of claim 1, wherein the threshold value is determined based on a profile indicating a voltage of the anode according to the SoC of the battery.

3. The charging control method of claim 2, wherein the threshold value is determined based on a SoC corresponding to an inflection point of the profile.

4. The charging control method of claim 3, wherein, based on the profile, the threshold value is determined based on a SoC corresponding to the inflection point where the voltage of the anode increases, then decreases, and then increases again as the battery is charged.

5. The charging control method of claim 2, wherein the threshold value is determined further based on at least one of temperature, humidity, pressure and a state-of-health (SoH).

6. The charging control method of claim 1, wherein the threshold value is determined, by analyzing chemical reactions that occur at the anode during a charging process of the battery, based on a SoC of a point at which a ratio of a lithium metal reaction among the chemical reactions decreases to equal to or less than a threshold ratio.

7. The charging control method of claim 1, wherein the first C-rate and the second C-rate have a difference that is determined based on at least one of temperature, humidity, pressure and a SoH.

8. The charging control method of claim 1, wherein the second C-rate is selected in a range exceeding the first C-rate and equal to or less than a third C-rate.

9. The charging control method of claim 8, wherein the third C-rate is selected as a largest in size, among candidate C-rates that at least one of the discharge capacity remaining ratio and Coulombic efficiency for a charging result applied in response to reaching the threshold value is identified as being included in a normal range.

10. The charging control method of claim 1, wherein the first C-rate is 0.2C and the second C-rate is 0.5C when the battery comprises sulfur as at least a portion of a cathode.

11. A non-transitory computer-readable recording medium having a program for executing the method of any one of claims 1 to 10 on a computer.

12. A battery management system configured to control charging a battery comprising lithium metal as at least a portion of an anode, the battery management system comprising:
one or more sensors;
a processor; and
a memory configured to store one or more instructions,
wherein the processor is configured to, by executing the one or more instructions, charge the battery based on a first C-rate, and charge the battery based on a second C-rate that is higher than the first C-rate in response to that a SoC of the battery reaches a threshold value.

13. The battery management system of claim 12, wherein the threshold value is determined based on a profile indicating a voltage of the anode according to the SoC of the battery.

14. The battery management system of claim 13, wherein the threshold value is determined based on a SoC corresponding to an inflection point of the profile.

15. The battery management system of claim 14, wherein, based on the profile, the threshold value is determined based on a SoC corresponding to the inflection point where the voltage of the anode increases, then decreases, and then increases again as the battery is charged.

16. The battery management system of claim 13, wherein the threshold value is determined further based on at least one of temperature, humidity, pressure and a SoH.

17. The battery management system of claim 12, wherein the threshold value is determined, by analyzing chemical reactions that occur at the anode during a charging process of the battery, based on a SoC of a point at which a ratio of a lithium metal reaction among the chemical reactions decreases to equal to or less than a threshold ratio.

18. The battery management system of claim 12, wherein the first C-rate and the second C-rate have a difference that is determined based on at least one of temperature, humidity, pressure and a SoH.

19. The battery management system of claim 12, wherein the second C-rate is selected in a range exceeding the first C-rate and equal to or less than a third C-rate.

20. The battery management system of claim 19, wherein the third C-rate is selected as a largest in size, among candidate C-rates that at least one of the discharge capacity remaining ratio and Coulombic efficiency for a charging result applied in response to reaching the threshold value is identified as being included in a normal range.

21. The battery management system of claim 12, wherein the first C-rate is 0.2C and the second C-rate is 0.5C when the battery comprises sulfur as at least a portion of a cathode.
